# EUROPEAN PATENT APPLICATION

(11) **EP 2 086 016 A2**
(43) Date of publication of application: **05.08.2009**
(21) Application number: 09250254.1
(22) Date of filing: 30.01.2009
(51) Int. Cl.: H01L 31/0232, H01L 31/052, H01L 31/048

(54) **Solar cell module**

(30) Priority: 31.01.2008 JP 2008021864; 19.12.2008 JP 2008324046
(71) Applicant: SANYO Electric Co., Ltd., Moriguchi-shi Osaka 570-8677 (JP)
(72) Inventor: Taguchi, Mikio, Moriguchi-shi, Osaka 570-8677 (JP)
(74) Representative: Calderbank, Thomas Roger

(57) **Abstract**

A solar cell module includes high refractivity layers each being formed between a light-receiving surface of a solar cell and a sealing member and having a refractive index higher than that of the sealing member. The high refractivity layers each have a pair of first tilted surfaces provided on a thin wire electrode (a collecting electrode) and tilted relative to the light-receiving surface.

## Description

This application is based upon and claims the benefit of priority from prior Japanese Patent Application No.2008-21864, filed on January 31 2008, and No.2008-324046, filed on December 19 2008; the entire contents of which are incorporated herein by reference.

The present invention relates to a solar cell module in which a first solar cell and a second solar cell are sealed between a front surface protection member and a back surface protection member in a sealing member.

Solar cells are expected as a new energy source since they can directly convert sunlight, which is clean and inexhaustibly supplied energy, into electricity.

Generally, a solar cell module has a configuration in which multiple solar cells are sealed between a front surface protection member and a back surface protection member in a sealing member. Each solar cell includes a photoelectric conversion part for generating photogenerated carriers and collecting electrodes for collecting carriers from the photoelectric conversion part.

In such a solar cell, sunlight beams incident toward the collecting electrodes are reflected by the collecting electrodes. For this reason, the photoelectric conversion part cannot utilize the sunlight beams incident toward the collecting electrodes for photoelectric conversion.

Hence, a technique to refract sunlight beams incident toward the collecting electrodes with V-shaped grooves formed on the front surface protection member has been proposed (see, Japanese Examined Patent Application Publication No. Hei 6-71093). This technique makes it possible to direct a sunlight beam incident toward each collecting electrode to an area of the light-receiving surface of the photoelectric conversion part where no collecting electrode is formed.

There is a problem, however, that when a solar cell module to which this technique is applied has been used for a long period of time, dirt deposited in the V-shaped grooves blocks sunlight.

Thus, a technique to refract or totally reflect sunlight beams incident toward the collecting electrodes by forming air bubbles in the sealing member at positions right above the collecting electrodes has been proposed (see, Japanese Patent Application Publication No. 2006-40937).

However, with the technique described in Japanese Patent Application Publication No. 2006-40937, it is difficult to control sizes, shapes, positions or the like of the air bubbles, since the air bubbles are generated with a blowing agent provided above or among the collecting electrodes. Accordingly, the technique does not allow sunlight beams that are refracted or totally reflected by the air bubbles to be accurately directed to the areas on the light-receiving surface of the photoelectric conversion part where no collecting electrode is formed.

The present invention has been made in light of the above circumstances. Accordingly, a preferred aim of the present invention is to provide a solar cell module that can direct a sunlight beam incident toward a collecting electrode to an area on the light-receiving surface of a photoelectric conversion part where no collecting electrode is formed.

One characteristic of the present invention is summarized as a solar cell module in which a first solar cell and a second solar cell are sealed between a front surface protection member and a back surface protection member in a sealing member, the solar cell module comprising a high refractivity layer provided between the first solar cell and the sealing member and having a refractive index higher than the sealing member. In the solar cell, the first solar cell includes: a photoelectric conversion part for generating photogenerated carriers by receiving light; a collecting electrode formed on a light-receiving surface of the photoelectric conversion part and collecting carriers from the photoelectric conversion part, and the high refractivity layer has a first tilted surface that is provided above the collecting electrode and tilted relative to the light-receiving surface.

With the solar cell module according to the one aspect of the present invention, sunlight beam incident toward the collecting electrode can be refracted on the first tilted surface and thereby directed to an area on the light-receiving surface of the photoelectric conversion part where no collecting electrode is formed. As a result, since the sunlight beams incident toward the collecting electrodes can be utilized in photoelectric conversion in the photoelectric conversion parts, electric generating capacity of the solar cell module can be improved.

In one aspect of the present invention, the first tilted surface may be convexly curved toward the front surface protection member.

In one aspect of the present invention, the high refractivity layer may have a side connecting between a top of the first tilted surface and the light-receiving surface, and the first tilted surface and the side may form a curved surface.

In one aspect of the present invention, the high refractivity layer may have an first notch formed along the collecting electrode, the first notch may be formed of a pair of first tilted surfaces that meet each other above the collecting electrode, and the pair of the first tilted surfaces may include the first tilted surface described above.

In one aspect of the present invention, each of the paired first tilted surfaces may be flat.

In one aspect of the present invention, each of the paired first tilted surfaces may be convexly curved toward the front surface protection member.

In one aspect of the present invention, the high refractivity layer may be formed along the collecting electrode.

In one aspect of the present invention, the high refractivity layer may be made of a macromolecule polymer.

In one aspect of the present invention, the high refractivity layer may be bonded to the light-receiving surface with a bonding member.

In one aspect of the present invention, the solar cell module may further include a wiring member for electrically connecting the first solar cell and the second solar cell to each other. In the solar cell module, the wiring member is placed on the light-receiving surface of the photoelectric conversion part of the first solar cell so as to extend in a predetermined direction, and the high refractivity layer has a second tilted surface that is being provided above the wiring member and tilted relative to the light-receiving surface.

In one aspect of the present invention, the high refractivity layer may have a second notch formed along the collecting electrode, the second notch may be formed of a pair of second tilted surfaces that meet each other above the wiring member, and the paired second tilted surfaces may include the second tilted surface according to claim 10

The present invention makes it possible to provide a solar cell module in which sunlight beams incident toward collecting electrodes can be directed to an area on a light-receiving surface of a photoelectric conversion part where no collecting electrode is formed.

### IN THE DRAWINGS

Fig. 1 is a side elevation of a solar cell module 100 according to a first embodiment of the present invention.
Fig. 2 is a plane view of a solar cell 10 according to the first embodiment of the present invention.
Fig. 3 is a plane view of a solar cell string 1 according to the first embodiment of the present invention.
Fig. 4 is a perspective view of a high refractivity layer 12 according to the first embodiment of the present invention.
Fig. 5 is an enlarged sectional view of a section A-A in Fig. 4.
Fig. 6 is a schematic view showing sunlight beams incident on the high refractivity layer 12 according to the first embodiment of the present invention.
Fig. 7 is a perspective view of a high Refractivity layer 12 according to a second embodiment of the present invention.
Fig. 8 is an enlarged sectional view of a section B-B in Fig. 7.
Fig. 9 is a schematic view showing sunlight beams incident on the high Refractivity layer 12 according to the second embodiment of the present invention.
Fig. 10 is a side elevation of a solar cell module 100 according to a third embodiment of the present invention.
Fig. 11 is a view illustrating a method of manufacturing the solar cell module 100 according to the third embodiment of the present invention.
Fig. 12 is a perspective view showing a high refractivity layer 12A according to a fourth embodiment of the present invention.
Fig. 13 is an enlarged sectional view of a section C-C in Fig. 12.
Figs. 14A to 14C are views illustrating a method of forming the high refractivity layer 12A according to the fourth embodiment of the present invention.
Fig. 15 is a schematic view showing sunlight beams incident on the high refractivity layer 12A of the fourth embodiment of the present invention.
Fig. 16 is an enlarged sectional view showing high refractivity layers 12B according to a fifth embodiment of the present invention.
Fig. 17 is a schematic view showing sunlight beams incident on the high refractivity layers 12B according to the fifth embodiment of the present invention.
Fig. 18 is an enlarged sectional view showing high refractivity layers 12C according to a sixth embodiment of the present invention.
Figs. 19A to 19C are views illustrating a method of forming the high refractivity layers 12C according to the sixth embodiment of the present invention.
Figs. 20A and 20B are schematic views showing sunlight beams incident on the high refractivity layers 12C according to the sixth embodiment of the present invention.

Embodiments of the invention will be described hereinafter with reference to the drawings. In the following description of the drawings, the same or similar parts are given the same or similar reference numerals. It should be noted, however, that the drawings are schematic and the dimensional proportions and the like differ from their actual values. Hence, specific dimensions or the like should be determined by considering the following description. It is also needless to say that dimensional relationships and dimensional proportions may be different from one drawing to another in some parts.

### [First Embodiment]

### (Outline configuration of a solar cell module)

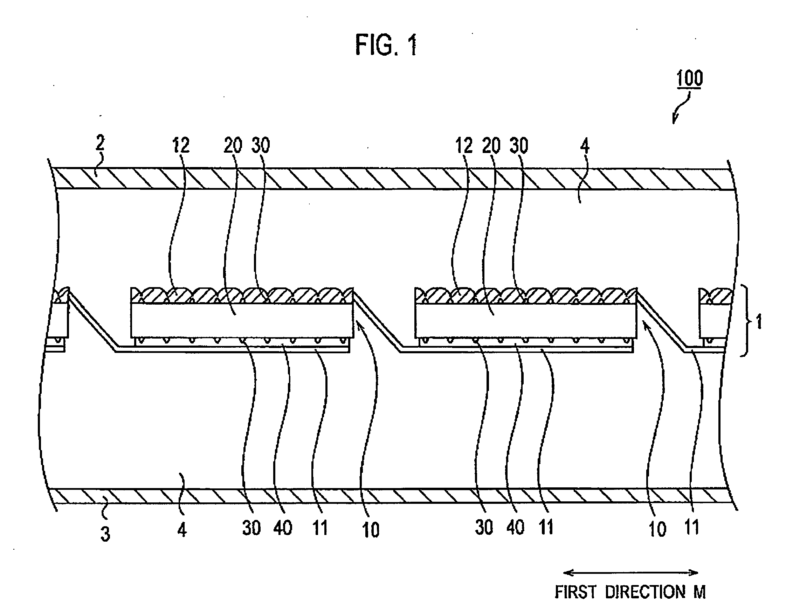

An outline configuration of a solar cell module 100 according to a first embodiment of the present invention will be described with reference to Fig. 1. Fig. 1 is an enlarged side elevation of the solar cell module 100 according to the embodiment.

The solar cell module 100 includes a solar cell string 1, a front surface protection member 2, a back surface protection member 3, a sealing member 4, wiring members 11, and high refractivity layers 12. The solar cell module 100 is configured by sealing the solar cell string 1 and the high refractivity layers 12 between the front surface protection member 2 and the back surface protection member 3.

The solar cell string 1 is configured by electrically connecting multiple solar cells 10 to each other, arranged in a first direction M, by wiring members 11.

Each solar cell 10 has a photoelectric conversion part 20 and electrodes formed on the photoelectric conversion part 20. The photoelectric conversion part 20 has a light-receiving surface on which sunlight beams are incident and a back surface provided on the opposite side of the light-receiving surface. The light-receiving surface and the back surface are main surfaces of the solar cell 10. A configuration of the solar cell 10 will be described later.

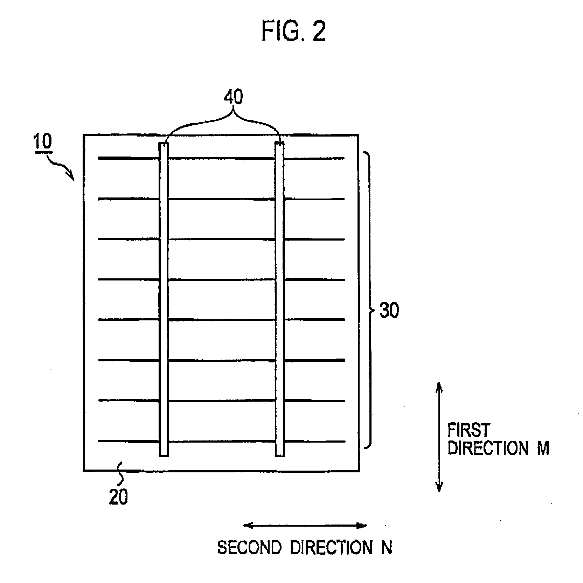

The wiring members 11 electrically connect the multiple solar cells 10 to each other. Specifically, each wiring member 11 is connected to a connecting electrode 40 (not shown in Fig. 1. See Fig. 2.) formed on the light-receiving surface of one solar cell 10 and a connecting electrode 40 formed on the back surface of another solar cell 10 adjacent to the one solar cell.

The high refractivity layers 12 are formed on the light-receiving surfaces of the photoelectric conversion parts 20. The high refractivity layers 12 have a higher refractive index (absolute refractive index) than the sealing member 4 to be described later. The high refractivity layers 12 also have a lower refractive index than the photoelectric conversion parts 20 to be described later.

As the high refractivity layers 12, a thermosetting resin such as polyimide, fluorene acrylate, a fluorene epoxy resin, an episulfide resin, a thiourethane resin, polyester methacrylate, polycarbonate or the like, or a high refractivity material such as titanium dioxide, silicon nitride, silicon carbide, zinc oxide, zirconium oxide, aluminum oxide or the like can be used. In consideration of handling in manufacturing processes, it is preferable to use a mixture of particles composed of the high refractivity material as described above and a resin material such as a thermosetting macromolecule polymer, or a silicone resin, a fluorine macromolecule material or the like. In addition, a material having a high refractive index (refractive index n = approximately 2.0, for example) can be obtained by mixing particles of titanium dioxide, zirconium oxide, or silicon nitride into a macromolecule polymer. A configuration of the high refractivity layers 12 will be described later.

The front surface protection member 2, placed on the light-receiving surface side of the sealing member 4, protects a front surface of the solar cell module 100. As the front surface protection member 2, a glass having translucency and water barrier properties, translucent plastics or the like can be used.

The back surface protection member 3, placed on the back surface side of the sealing member 4, protects the back surface of the solar cell module 100. As the back surface protection member 3, a resin film such as PET (Polyethylene Terephthalate) or the like or a laminated film having such a structure that an A1 foil is sandwiched by resin films or the like can be used.

The sealing member 4 seals the solar cell string 1 and the high refractivity layers 12 between the front surface protection member 2 and the back surface protection member 3. As the sealing member 4, a translucent resin such as an EVA resin, an EEA resin, a PVB resin, a silicone resin, a urethane resin, an acrylic resin, an epoxy resin or the like can be used. A refractive index of the sealing member 4 is smaller than that of the high refractivity layers 12.

In addition, an A1 frame (not shown) can be attached to the periphery of the solar cell module 100 having the configurations described above.

### (Configuration of solar cells)

A configuration of solar cells 10 will be described hereinafter with reference to Fig. 2. Fig. 2 is a plane view of the light-receiving surface side of the solar cell 10.

As shown in Fig. 2, the solar cell 10 includes a photoelectric conversion part 20, multiple thin wire electrodes 30, and connecting electrodes 40.

The photoelectric conversion part 20 generates photogenerated carriers by receiving light on the light-receiving surface. Photogenerated carriers refer to holes and electrons to be generated as a result of sunlight beams being absorbed by the photoelectric conversion part 20. The photoelectric conversion part 20 has an n-type region and a p-type region therein, and a semiconductor junction is formed at the interface between the n-type region and the p-type region. The photoelectric conversion part 20 can be formed by using a semiconductor substrate formed of a semiconductor material such as a crystal semiconductor material or a compound semiconductor material. Examples of such a crystal semiconductor material include a single crystal Si, a polycrystalline Si and the like, and examples of such a compound semiconductor material include GaAs, InP and the like. Note that, the photoelectric conversion part 20 may have a structure, namely, a so-called HIT structure, having improved properties of a hetero junction interface by sandwiching a substantially intrinsic amorphous silicon layer between a single crystal silicon substrate and an amorphous silicon layer.

The thin wire electrodes 30 are collecting electrodes that collect carriers from the photoelectric conversion part 20. As shown in Fig. 2, the multiple thin wire electrodes 30 are formed on the photoelectric conversion part 20 in a second direction N that is substantially perpendicular to the first direction M. The thin wire electrodes 30 can be formed by a printing method, using a resin type conductive paste that includes a resin material as a binder and conducting particles such as silver particles or the like as a filler, or a sintered type conductive paste (a so-called ceramic paste) containing silver powder, a glass frit, an organic vehicle, an organic solvent and the like.

As shown in Fig. 1, the thin wire electrodes 30 can also be similarly formed on the back surface of the photoelectric conversion part 20. The number of thin wire electrodes 30 can be set to an appropriate number, considering size or the like of the photoelectric conversion part 20. For example, when the photoelectric conversion part 20 is an approximately 100 mm square, about 50 thin electrode wires can be formed.

The connecting electrodes 40 are electrodes to be used to connect the wiring members 11 to the solar cells 10. As shown in Fig. 2, the connecting electrodes 40 are formed on the light-receiving surface of the photoelectric conversion part 20 in the first direction M. Thus, the connecting electrodes 40 intersect with the multiple the thin wire electrodes 30. Similar to the thin wire electrodes 30, the connecting electrodes 40 can be formed by the printing method, using the resin type conductive paste or sintered type conductive paste.

As shown in Fig. 1, the connecting electrodes 40 are also formed on the back surface of the photoelectric conversion part 20. The number of connecting electrodes 40 can be set to an appropriate number considering size or the like of the photoelectric conversion part 20. For example, when the photoelectric conversion part 20 is an approximately 100 mm square, two connecting electrodes 40 having a width of approximately 1.5 mm can be formed.

In addition, electrodes formed on the back surface of the photoelectric conversion part 20 are not limited to the configuration as described above but other configurations may be used. For example, a part of a conductive film formed on the substantially whole back surface of the photoelectric conversion part 20 may be used as connecting electrodes or separate connecting electrodes may be provided on the conductive film.

### (Configuration of Solar Cell String)

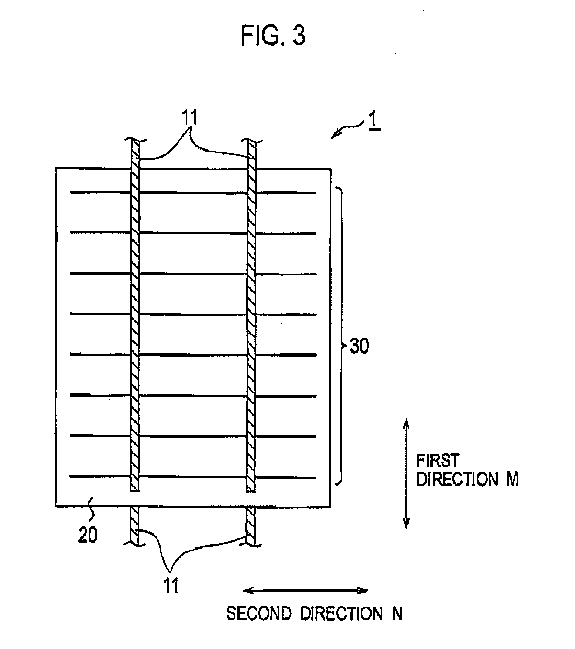

A configuration of a solar cell string 1 will be described hereinafter with reference to Fig. 3. Fig. 3 shows the state in which the wiring members 11 are placed on the connecting electrodes 40 as shown in Fig. 2.

As shown in Fig. 3, the wiring members 11 are placed on the connecting electrodes 40 that are linearly formed in the first direction M. In other words, the wiring members 11 are placed on the photoelectric conversion part 20 in the first direction M. The width of each wiring member 11 may be substantially equal to or smaller than that of the connecting electrodes 40.

### (Configuration of High Refractivity Layers 12)

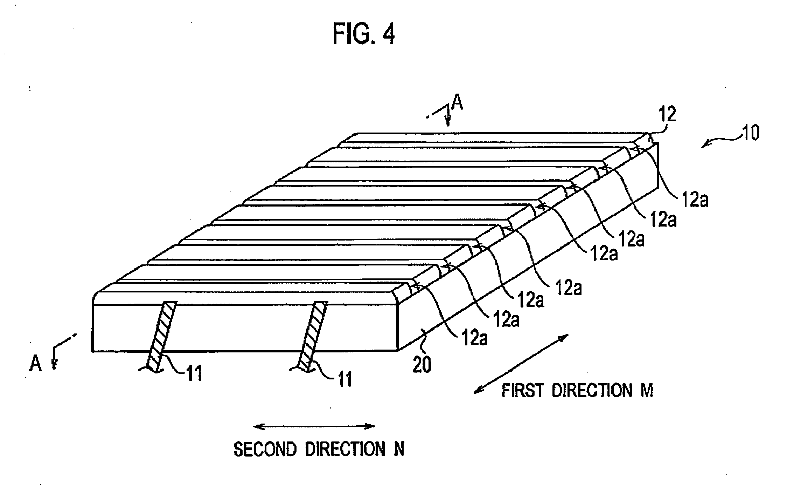

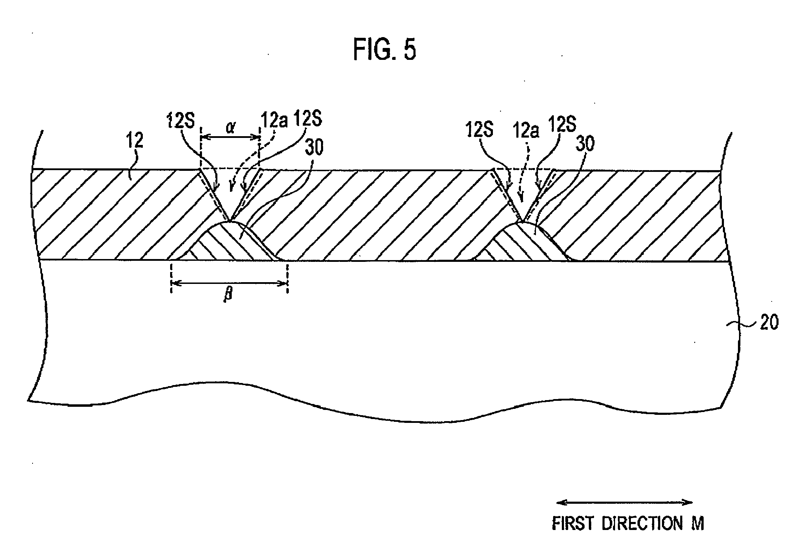

A configuration of the high refractivity layers 12 will be described hereinafter with reference to Fig. 4 and Fig. 5. Fig. 4 is a perspective view showing a state in which the high refractivity layer 12 is formed on the light-receiving surface of the solar cell 10. Fig. 5 is an enlarged sectional view of A-A section in Fig. 4, that is, a section perpendicular to the second direction N in which the thin wire electrodes 30 extend.

As shown in Fig. 4, the high refractivity layer 12 has first notches 12a formed along the thin wire electrodes 30 (not shown in Fig. 4. See Fig. 3.) that are formed on the light-receiving surface of the photoelectric conversion part 20. In the embodiment, as the eight thin wire electrodes 30 are formed on the photoelectric conversion part 20 in the second direction N, the high refractivity layer 12 has the eight first notches 12a in the second direction N.

As shown in Fig. 5, each first notch 12a is formed of a pair of first tilted surfaces 12S and 12S. The pair of the first tilted surfaces 12S and 12S is provided on the thin wire electrode 30. Each of the first tilted surfaces 12S and 12S in the pair tilts to the light-receiving surface of the photoelectric conversion part 20. The pair of the first tilted surfaces 12S and 12S meet above the approximate center of the thin wire electrode 30.

In this way, each first notch 12a is formed so that the notch 12a gradually deepens toward the thin wire electrode 30. In other words, the first notch 12a is formed so that the section thereof perpendicular to the second direction N has an inverted triangle shape (V-shape) having a vertex right above the approximate center of the thin wire electrode 30 in the first direction M. Thus, thickness of the high refractivity layer 12 is smallest at the approximate center of the thin wire electrode 30 in the first direction M, and the farther in the first direction M the high refractivity layer 12 goes from the approximate center of the thin wire electrode 30 in the first direction M, the larger the thickness of the high refractivity layer 12 becomes.

In addition, each first notch 12a is filled with the sealing member 4. Thus, in the notch 12a, the sealing member 4 is in contact with a pair of the first tilted surfaces 12S and 12S of the high refractivity layer 12.

In Fig. 5, although the width α of the first notch 12a is smaller than the width β of the thin wire electrode 30, the width α of the first notch 12a may be substantially equal to or larger than the width β of the thin wire electrode 30.

One example of a method of forming the high refractivity layer 12 will be described hereinafter. First, the multiple solar cells 10 are connected to each other by the wiring members 11. Then, a high refractivity material of thermosetting type is applied onto the light-receiving surface of each solar cell 10. Next, the applied high refractivity material is cured by being heated while pressing a top panel that has convex portions corresponding to the thin wire electrodes 30, against the high refractivity material. As a result, each high refractivity layer 12 having pairs of the first tilted surfaces 12S and 12S are formed.

### (Operation and Effect)

The solar cell module 100 according to this embodiment includes the high refractivity layer 12 being formed on the light-receiving surface of the photoelectric conversion part 20 and having a refractive index higher than that of the sealing member 4. The high refractive layer 12 has pairs of the first tilted surfaces 12S and 12S each being provided above the thin wire electrode 30 (collecting electrode) and having pairs of the first tilted surfaces 12S and 12S tilted relative to the light-receiving surface.

Thus, sunlight beams incident toward each thin wire electrode 30 are refracted at the pair of the first tilted surfaces 12S and 12S, and thereby can be directed to an area of the light-receiving surface of the photoelectric conversion part 20 where no thin wire electrode 30 is formed.

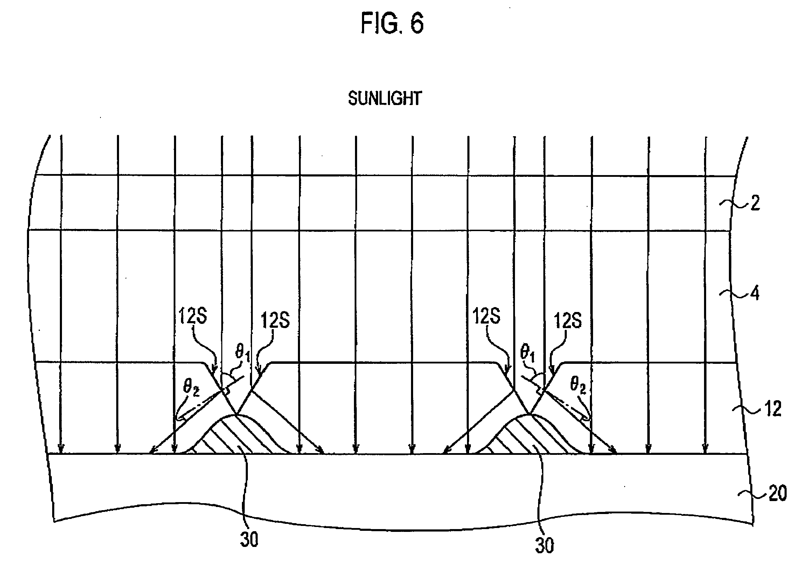

Specifically, as shown in Fig. 6, sunlight beams passing through the front surface protection member 2 and being incident toward the thin wire electrode 30 through the sealing member 4 are refracted at the pair of the first tilted surfaces 12S and 12S. The refracted sunlight beams are directed to the area of the light-receiving surface of the photoelectric conversion part 20 where no thin wire electrode 30 is formed. At this time, since the high refractivity layer 12 has a refractive index higher than that of sealing member 4, an output angle θ2 can be made smaller than an incident angle θ1. Consequently, sunlight beams incident on the pair of the first tilted surfaces 12S and 12S can be efficiently directed to an effective light receiving area of the light-receiving surface of the photoelectric conversion part 20. As a result, the photoelectric conversion part 20 can absorb sunlight beams incident toward the thin wire electrodes 30.

Consequently, since sunlight beams incident toward the thin wire electrodes 30 can be utilized for photoelectric conversion in the photoelectric conversion part 20, the electric generating capacity of the solar cell module 100 can be improved.

### [Second Embodiment]

A second embodiment of the present invention will be described hereinafter with reference to the drawings. This embodiment differs from the first embodiment described above in that high refractivity layers 12 according to this embodiment further include second notches 12b. Since this embodiment is similar to the first embodiment described above in other points, the differences will be mainly described hereinafter with reference to Fig. 1 to Fig. 3.

### (Configuration of High Refractivity Layers 12)

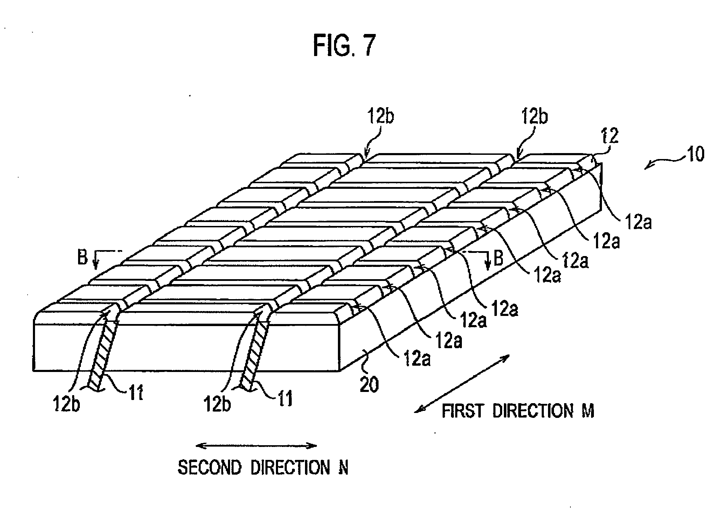

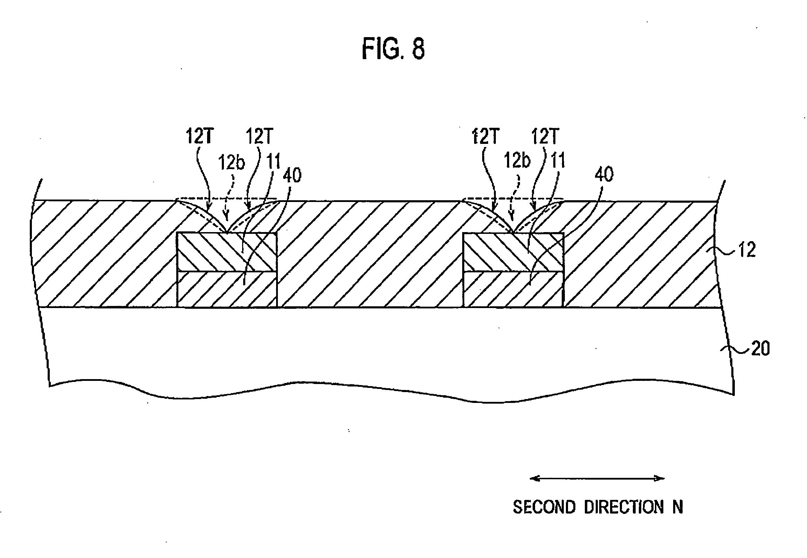

Fig. 7 is a perspective view schematically showing a state in which the high refractivity layer 12 is formed on the light-receiving surface of the solar cell 10. Fig. 8 is an enlarged sectional view of a section B-B in Fig. 7, i.e., of a section perpendicular to the first direction M in which the wiring members 11 extend.

As shown in Fig. 7, the high refractivity layer 12 according to this embodiment has second notches 12b that are formed along the wiring members 11 (See Fig. 3.) placed on the photoelectric conversion part 20. In this embodiment, since two wiring members 11 are placed on the photoelectric conversion part 20 in the first direction M, the high refractivity layer 12 has two second notches 12b in the first direction M.

As shown in Fig. 8, each second notch 12b is formed by a pair of second tilted surfaces 12T and 12T. The pair of the second tilted surfaces 12T and 12T is provided on the thin wire electrode 30. Each of the paired second tilted surfaces 12T and 12T is tilted relative to the light-receiving surface of the photoelectric conversion part 20. The pair of the second tilted surfaces 12T and 12 meet above the approximate center of the wiring member 11.

In this way, each second notch 12b is formed so that the notch 12b gradually deepens toward the wiring member 11. In other words, the second notch 12b is formed so that the section perpendicular to the first direction M has an inverted triangle shape (V-shape) having a vertex at the approximate center of the wiring member 11 in the second direction N. Thus, thickness of the high refractivity layer 12 is smallest at the approximate center of the wiring member 11 in the second direction N, and the farther in the second direction N the high refractivity layer 12 goes from the approximate center of the wiring member llin the second direction N, the larger thickness of the high refractivity layer 12 becomes.

In addition, each second notch 12b is filled with the sealing member 4. Thus, in the second notch 12b, the sealing member 4 is in contact with a pair of the second tilted surfaces 12T and 12T of the high refractivity layer 12.

In Fig. 8, although the width of the second notches 12b is substantially equal to that of the wiring members 11; however, the width may be formed larger than the width of the wiring members 11.

Additionally, the configuration of the first notch 12a is similar to that of the first embodiment described above. The first notch 12a and the second notches 12b are formed so that they intersect like a grid in the plane view of the high refractivity layer 12.

Then, one example of a method of forming the high refractivity layer 12 will be described hereinafter. First, the multiple solar cells 10 are connected to each other by the wiring members 11. Then, a high refractivity material of thermosetting type is applied onto the light-receiving surface of each solar cell 10. Next, the applied high refractivity material is cured by being heated while pressing a top panel that has convex portions corresponding to the thin wire electrodes 30 and the wiring members 11, against the high refractivity material. As a result, each high refractivity layer 12 having pairs of the first tilted surfaces 12S and 12S and pairs of second tilted surfaces 12T and 12T are formed. (Operation and Effect)

The solar cell module 100 according to this embodiment includes the high refractivity layers 12 each being provided on the light-receiving surface of the photoelectric conversion part 20 and having a refractive index higher than that of the sealing member 4. The high refractive layer 12 has pairs of the second tilted surfaces 12T and 12T each being provided above the wiring member 11 and tilted relative to the light-receiving surface.

Thus, sunlight beams incident toward each wiring member 11 are refracted at the pair of the second tilted surfaces 12T and 12T, and thereby can be directed to an area of the light-receiving surface of the photoelectric conversion part 20 where no wiring member 11 is formed.

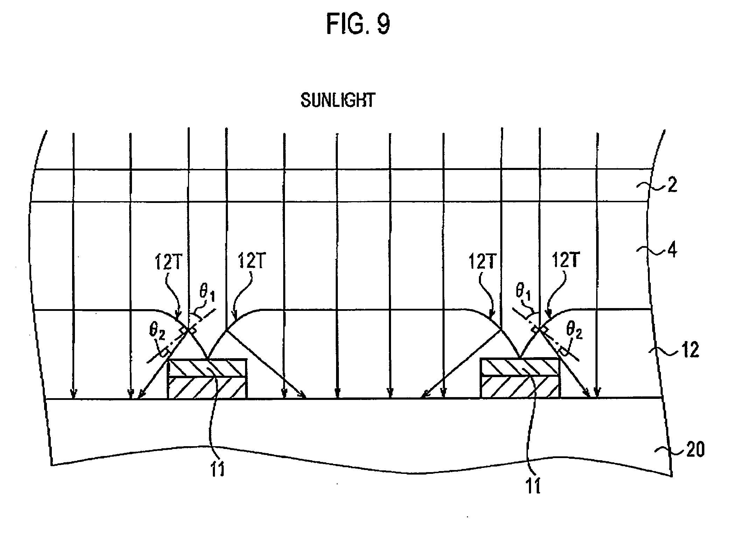

Specifically, as shown in Fig. 9, sunlight beams passing through the front surface protection member 2 and being incident toward the wiring members 11 through the sealing member 4 are refracted at the pair of the second tilted surfaces 12T and 12T. The refracted sunlight beams are directed to the area of the light-receiving surface of the photoelectric conversion part 20 where no wiring member 11 is formed. At this time, since the high refractivity layer 12 has a refractive index higher than the sealing member 4, an output angle θ2 can be made smaller than an incident angle θ1. Consequently, sunlight beams incident on the pair of the second tilted surfaces 12T and 12T can be efficiently directed to an effective light receiving area of the light-receiving surface of the photoelectric conversion part 20. As a result, the photoelectric conversion part 20 can absorb sunlight beams incident toward the wiring member 11.

In addition, similarly to the first embodiment described above, the pair of the first tilted surfaces 12S and 12S can direct sunlight beams incident toward the thin wire electrodes 30 to the area where no thin wire electrode 30 is formed.

Consequently, since sunlight beams incident toward the thin wire electrodes 30 and the wiring members 11 can be utilized for photoelectric conversion in the photoelectric conversion part 20, the electric generating capacity of the solar cell module 100 can be further improved.

### [Third Embodiment]

A third embodiment of the present invention will be described hereinafter with reference to the drawings. This embodiment differs from the first embodiment described above in that a separately formed high refractivity layer 12 is placed on the light-receiving surface of each solar cell 10. Since this embodiment is similar to the first embodiment described above in other points, the differences will be mainly described hereinafter.

### (Configuration of High Refractivity Layers 12)

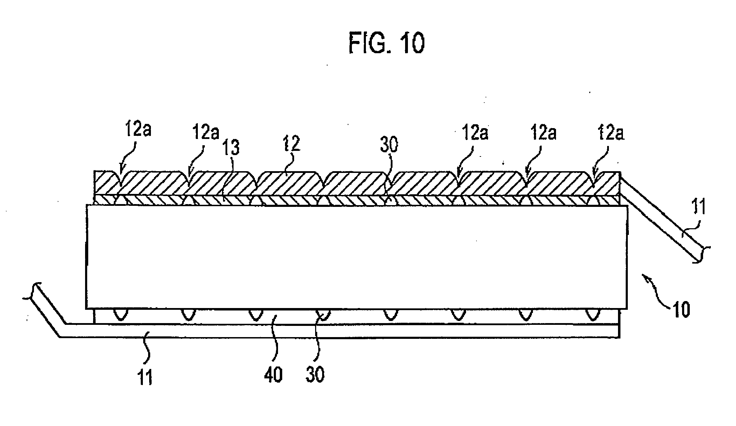

Fig. 10 is an enlarged side view of a solar cell module 100 according to this embodiment. As shown in Fig. 10, a high refractivity layer 12 according to this embodiment is bonded onto the light-receiving surface of the solar cell 10 with a bonding member 13.

The high refractivity layer 12 is a structure formed separately from the solar cell 10. The high refractivity layer 12 has the first notches 12a of the first embodiment described above.

A bonding member 13 is a resin for bonding the high refractivity layer 12 onto the light-receiving surface of the solar cell 10. Similarly to the sealing member 4, a translucent resin such as an EVA resin can be used as the bonding member 13.

### (Method of Manufacturing Solar Cell Module)

First, a high refractivity material of thermosetting type is injected into a mold that has been molded according to the shape of the high refractivity layer 12. Then, the high refractivity material in the mold is cured by heating the mold. As a result, the high refractivity layer 12 is formed.

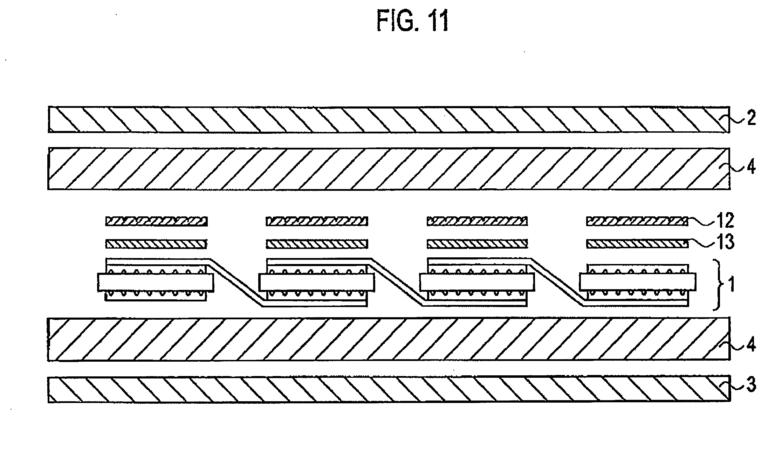

Next, as shown in Fig. 11, a laminated body is formed by sequentially stacking a PET sheet (a back surface protection member 3), an EVA sheet (the sealing member 4), a solar cell string 1, EVA sheets (the bonding members 13), the high refractivity layers 12, an EVA sheet (the sealing member 4), and a glass plate (a front surface protection member 2).

Next, the laminated body is heated and pressure bonded in a vacuum atmosphere. At this time, the EVA is softened and then filled into the first notch 12a. Thereafter, the EVA is cured. Accordingly, the solar cell module 100 is manufactured.

### (Operation and Effect)

Each high refractivity layer 12 according to this embodiment is formed as a structure separate from the solar cell 10. Thus, after the solar cell string 1 is formed, it is no longer necessary to form the high refractivity layers on respective light-receiving surfaces of the multiple solar cells 10. In other words, separately preparing the high refractivity layer 12 enables modularization of the high refractivity layer 12 together with other members. Consequently, the manufacturing processes can be simplified.

Note that, also with such high refractivity layers 12, sunlight beams incident toward the thin wire electrodes 30 can be directed by the first notch 12a to the area where no thin wire electrode 30 is formed, similarly to the first embodiment described above.

### [Fourth Embodiment]

Next, a fourth embodiment of the present invention will be described hereinafter with reference to the drawings. In the following, differences from the first embodiment described above will be mainly described. Specifically, in the first embodiment described above, the high refractivity layer 12 is formed to cover the substantially whole light-receiving surface of the photoelectric conversion part 20. In contrast, in the fourth embodiment, the high refractivity layer 12 is formed along the thin wire electrodes 30.

### (Configuration of the high refractivity layers)

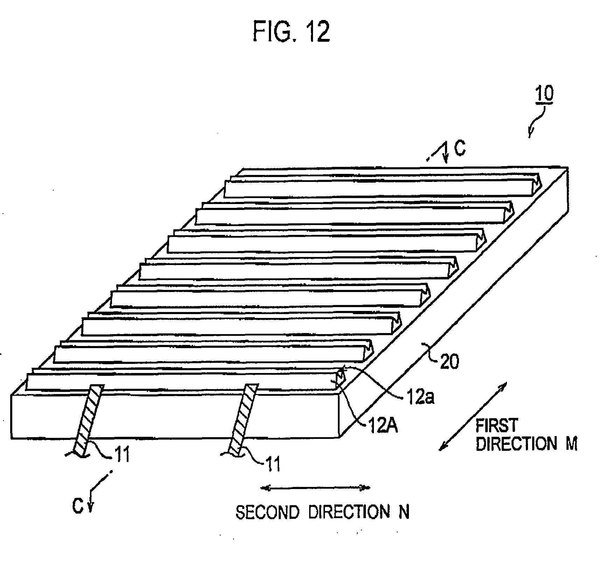

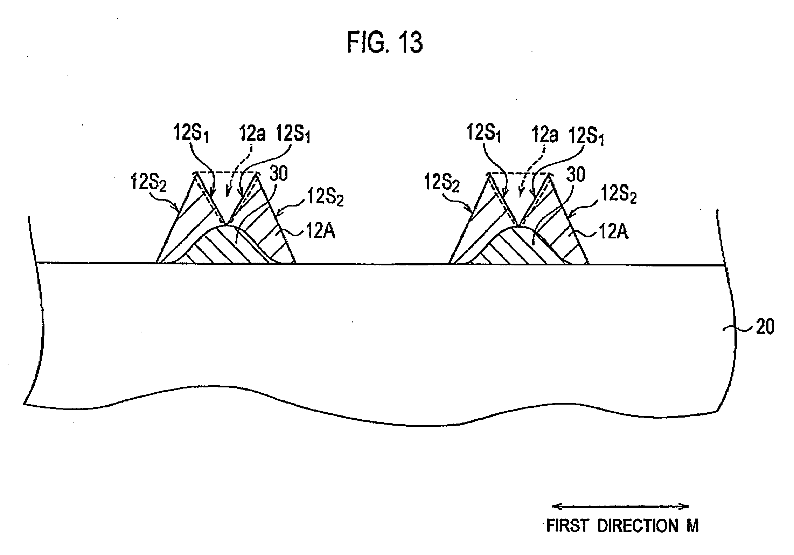

A configuration of the high refractivity layers 12A according to the forth embodiment will be described with reference to Fig. 12 and Fig. 13. Fig. 12 is a perspective view showing a state in which the multiple high refractivity layers 12A are formed on the light-receiving surface of the solar cell 10. Fig. 13 is an enlarged sectional view of a section C-C in Fig. 12.

As shown in Fig. 12, a solar cell module 100 includes the multiple high refractivity layers 12A formed on the light-receiving surface of the photoelectric conversion part 20. Each high refractivity layer 12A has the first notch 12a. Each high refractivity layer 12A is provided on the thin wire electrode 30 along the thin wire electrode 30.

As shown in Fig. 13, the first notch 12a is formed by a pair of first tilted surfaces 12S₁ and 12S₁. The pair of the first tilted surfaces 12S₁ and 12S₁ is provided above the thin wire electrode 30. Each of the paired first surfaces 12S₁ and 12S₁ is tilted relative to the light-receiving surface of the photoelectric conversion part 20. The pair of the first surfaces 12S₁ and 12S₁, each of which is formed flat, meet above the approximate center of the thin wire electrode 30.

In addition, the high refractivity layer 12A has a pair of sides 12S₂ and 12S₂. The pair of sides 12S₂ and 12S₂ are the surfaces of the high refractivity layers 12A extending from the tops of the pair of the first tilted surfaces 12S₁ and 12S₁ to the light-receiving surface of the photoelectric conversion part 20, respectively. The paired sides 12S₂ and 12S₂ meet and make acute angles with the paired first tilted surfaces 12S₁ and 12S₁, respectively.

One example of forming such a high refractivity layer 12A will be described with reference the drawings.

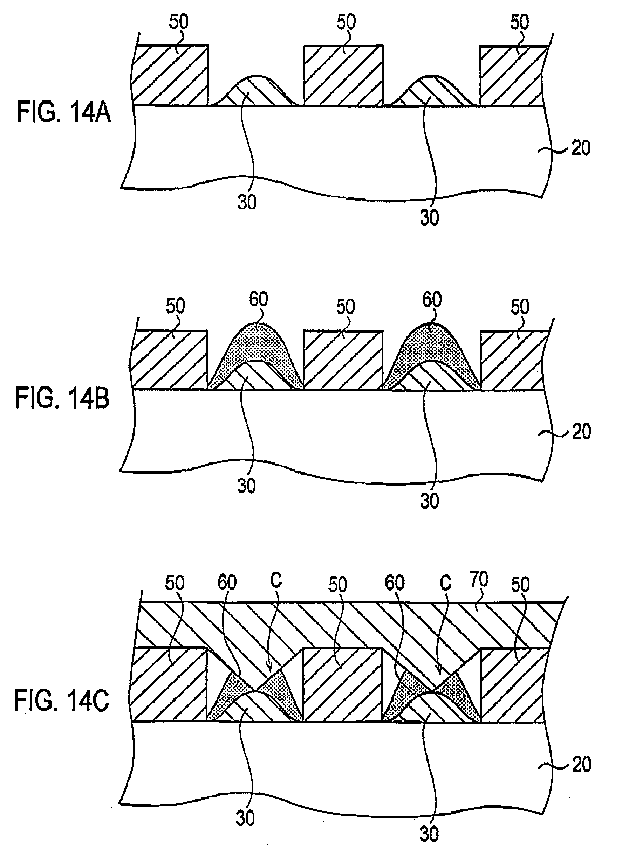

First, as shown in Fig. 14A, masks are applied on the light-receiving surface of the photoelectric conversion part 20 so that all thin wire electrodes 30 are exposed.

Secondly, as shown in Fig. 14B, a high refractivity material 60 of thermosetting type is applied on each thin wire electrode 30 along thereof.

Thirdly, as shown in Fig. 14C, the applied high refractivity material 60 is cured by being heated while pressing a top plate 70 that has convex portions corresponding to the respective thin wire electrodes 30 against the high refractivity material 60.

Fourthly, the top plate is taken off and the masks 50 are removed. As a result, each high refractivity layer 12A having the pair of the first tilted surfaces 12S₁ and 12S₁ and the pair of the sides 12S₂ and 12S₂.

### (Operation and Effect)

Since each high refractivity layer 12A according to this embodiment has the pair of the first tilted surfaces 12S₁ and 12S₁, similar effects to the first embodiment described above can be achieved.

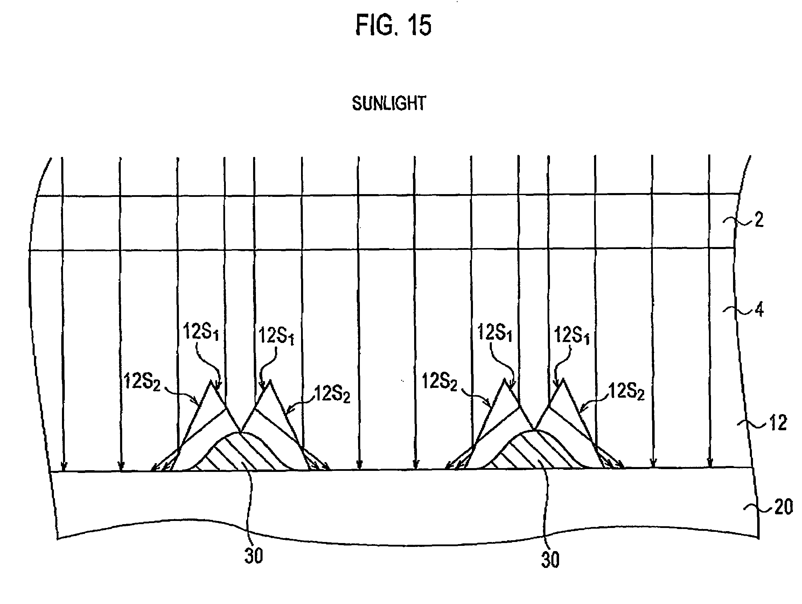

In addition, each high refractivity layer 12A according to the embodiment has the pair of the sides 12S₂ and 12S₂. Thus, as shown in Fig. 15, sunlight beams incident toward each thin wire electrode 30 can also be directed to an area on the light-receiving surface of the photoelectric conversion part 20 where no thin wire electrode 30 is formed, by refracting the sunlight beams at the pair of the sides 12S₂ and 12S₂.

Additionally, each high refractivity layer 12A according to this embodiment is formed along the thin wire electrode 30. Thus, since usage of the high refractive material is smaller than the case in which the high refractivity layer 12 is formed to cover the light-receiving surface of the photoelectric conversion part 20, manufacturing cost of the solar cell module 100 can be reduced.

### [Fifth Embodiment]

A fifth embodiment of the present invention will be described hereinafter with reference to the drawings. In the following, differences from the fourth embodiment described above will be mainly described. Specifically, in the fourth embodiment described above the high refractivity layers 12 are formed by using the masks. In contrast, high refractivity layers 12 are formed without using masks, in the fifth embodiment.

### (Configuration of High Refractivity Layers 12)

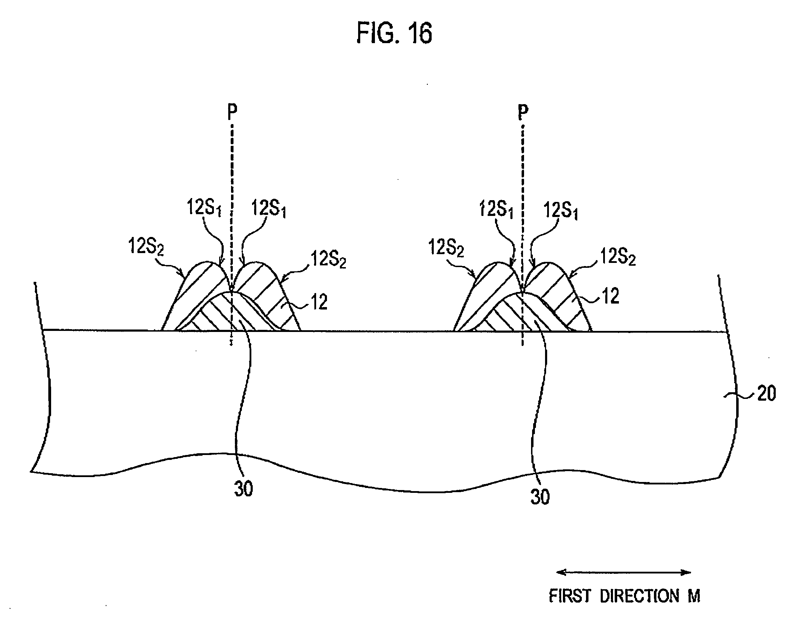

A configuration of the high refractivity layers 12B according to the fifth embodiment will be described with reference to Fig. 16. Fig. 16 is a sectional view of the solar cell 10 for illustrating the configuration of the high refractivity layer 12B.

As shown in Fig. 16, in the high refractivity layer 12B, the paired first tilted surfaces 12S₁ and 12S₁ are gently curved and then meet the paired sides 12S₂ and 12S₂, respectively. In other words, the paired first tilted surfaces 12S₁ and 12S₁ and the paired sides 12S₂ and 12S₂ form curved surfaces.

One example of forming such a high refractivity layer 12B will be described with reference to the drawings.

First, by means of a dispenser method, a high refractivity material 60 is applied symmetrically relative to a center line P of each thin wire electrode 30. In this case, the height of the high refractivity material 60 to be applied can be adjusted by adjusting scanning speed of a dispenser device or viscosity of the high refractivity material 60.

Then, the applied high refractivity material 60 is cured by being heated. As a result, each high refractivity layer 12B having the pair of the first tilted surfaces 12S₁ and 12S₁ and the pair of the sides 12S₂ and 12S₂.

### (Mode of operation and advantageous effect)

Since each high refractivity layer 12B according to the embodiment has the pair of the tilted surfaces 12S₁ and 12S₁ and the pair of the sides 12S₂ and 12S₂, the effects similar to those of the fourth embodiment described above can be achieved.

In addition, the high refractivity layer 12B according to the embodiment is formed without using masks, by means of the dispenser method. Thus, the manufacturing processes of the solar cell module 100 can be simplified, compared with the case in which the high refractivity layers are formed by using the masks.

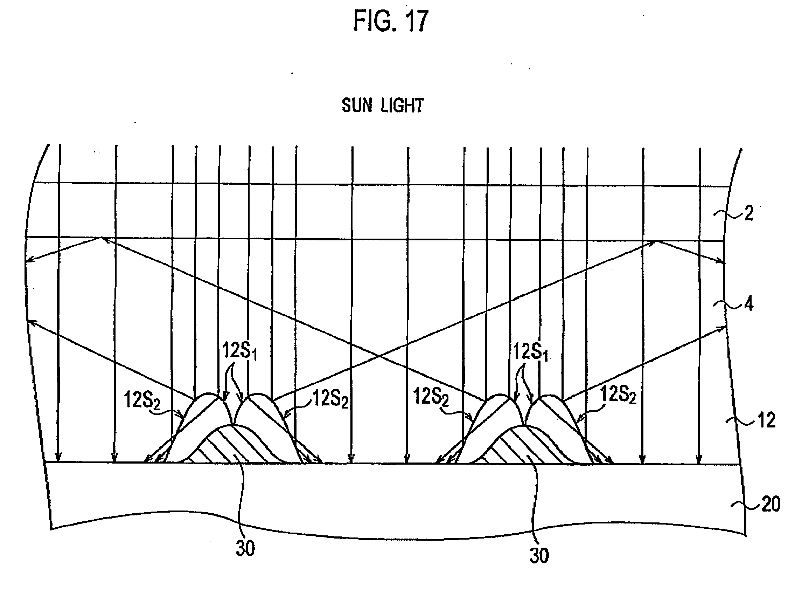

Furthermore, in the high refractivity layer 12B according to the embodiment, the paired first tilted surfaces 12S₁ and 12S₁ and the paired sides 12S₂ and 12S₂ gently meet, respectively, and form the curved surfaces. Thus, as shown in Fig. 17, an incident angle to the front surface protection member 2 of incident light reflected at the surface of the high refractivity layer 12B can be made larger. Thus, reflectivity at an interface between the front surface protection member 2 and the sealing member 4 can be increased. Consequently, the electric generating capacity of the solar cell module 100 can be further improved.

### [Sixth Embodiment]

A sixth embodiment of the present invention will be described hereinafter with reference to the drawings. In the following, differences from the fourth embodiment described above will be mainly described. Specifically, in the fourth embodiment described above, the high refractivity layer 12 has the pair of the first tilted surfaces 12 and 12S₁ and the pair of the sides 12S₂ and 12S₂. In contrast, a high refractivity layer 12 has one first tilted surface 12S₁ and one side 12S₂ in the sixth embodiment.

### (Configuration of High Refractivity Layers)

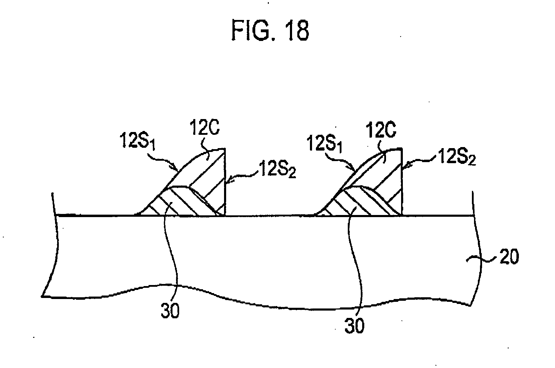

A configuration of the high refractivity layers 12C according to the sixth embodiment will be described with reference to Fig. 18. Fig. 18 is a sectional view of the solar cell 10 for illustrating the configuration of the high refractivity layer 12C.

As shown in Fig. 18, the high refractivity layer 12C according to the sixth embodiment has one first tilted surface 12S₁ and one side 12S₂. The first tilted surface 12S₁ covers one side of the surface of the thin wire electrode 30. The side 12S₂ is formed substantially perpendicular to the light-receiving surface of the photoelectric conversion part 20 on the light-receiving surface. The first tilted surface 12S₁ is formed to gradually diminish from the top of the side 12S₂ to the surface of the thin wire electrode 30, and convexly curved toward the front surface protection member 2.

One example of a method of forming such a high refractivity layer 12C will be described with reference to the drawings.

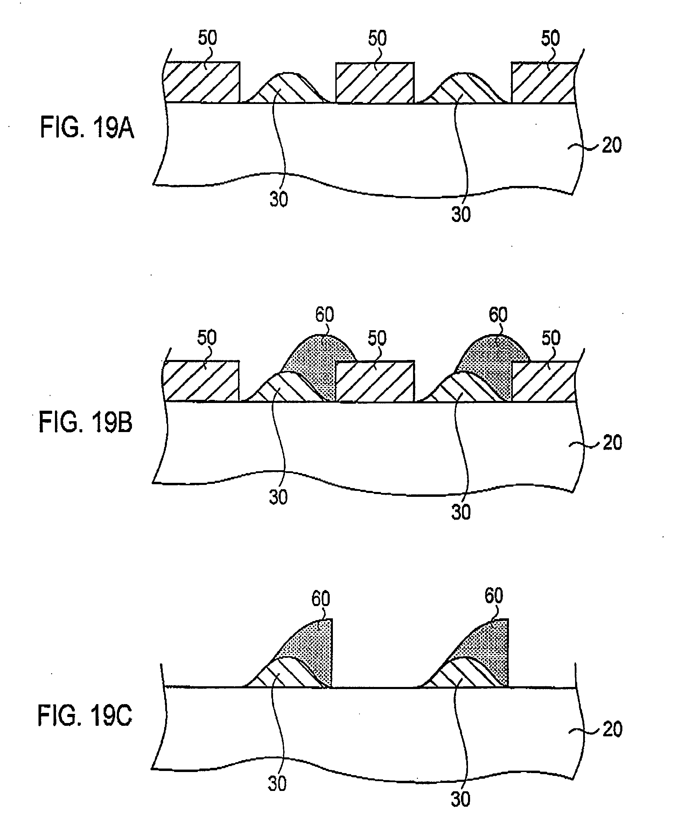

First, as shown in Fig. 19A, masks 50 are applied so that all thin wire electrodes 30 are exposed on the light-receiving surface of the photoelectric conversion part 20.

Secondly, as shown in Fig. 19B, by means of a dispenser method, a high refractivity material 60 of thermosetting type is applied so as to cover one side the surface of each thin wire electrode 30.

Thirdly, as shown in Fig. 19C, the high refractivity material 60 applied on the masks 50 is removed with the masks 50. Then, the remaining high refractivity material 60 is heated and cured. As a result, the high refractivity layer 12C having the one first tilted surface 12S₁ and the one side 12S₂ is formed.

### (Operation and Effect)

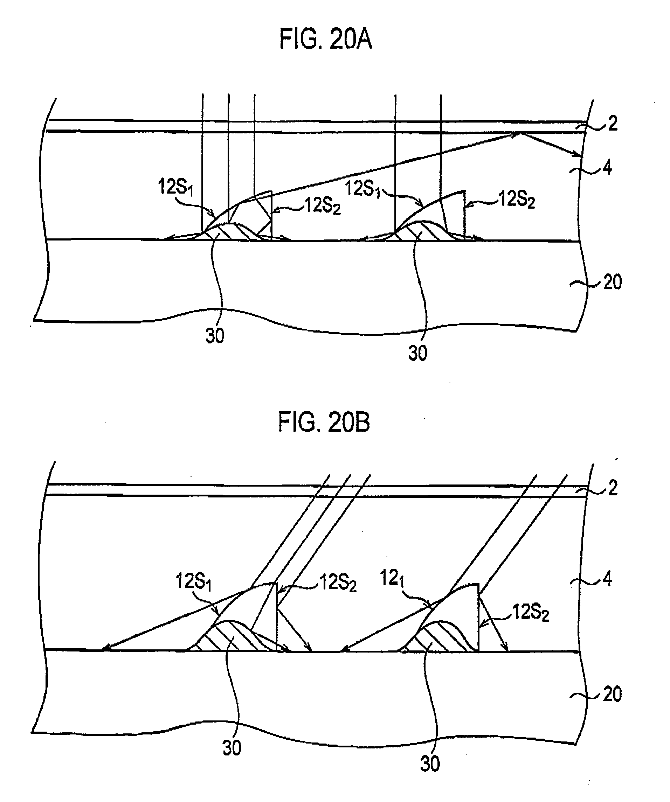

Since each high refractivity layer 12C according to this embodiment has the one first tilted surface 12S₁ and the one side 12S₂, the same effects as those of the first and fourth embodiments can be achieved as shown in Fig. 20A. In addition, as shown in Fig. 20A, since one end of the thin wire electrode 30 is tilted although it is exposed, light incident on the one end is easy to direct to the light-receiving surface.

Furthermore, the one first tilted surface 12S₁ is formed to gradually diminish from the top of the side 12S₂ to the surface of the thin wire electrode 30, and thus convexly curved toward the front surface protection member 2. Thus, as shown in Fig. 20B, even in the case where incident light enters obliquely the light-receiving surface, the incident light can be directed to the light-receiving surface efficiently. In addition, although in each of the above embodiments, obliquely incident light can be directed to the light-receiving surface, the shape like the high refractivity layer 12C can makes it easy to design the shape, which thereby can further improve the reflection efficiency of the incident light.

### [Other Embodiments]

Although the present invention was described with the embodiments described above, it should not be understood that a dissertation and drawings that form a part of the disclosure limit the present invention. Various alternative illustrative embodiments, embodiments, and operating technologies will become apparent from this disclosure.

For example, in the embodiments described above, although the multiple thin wire electrodes 30 are linearly formed along the second direction N, the shape of the thin wire electrode 30 is not limited to this. For example, the thin wire electrode 30 may also be formed on the wave line, or the multiple thin wire electrodes 30 may intersect like a grid.

In addition, in the embodiments described above, although the wiring members 11 are soldered onto the connecting electrodes 40, the wiring members 11 may be bonded onto the photoelectric conversion part 20 with a resin adhesive.

In addition, in the embodiments described above, sides of the notches (the first notch 12a and the second notches 12b) may not be planar shaped. In other words, the sides of the notches may be curved in consideration of the refractive index of the high refractivity layer 12.

In addition, in the above illustrative embodiments described above, although the multiple thin wire electrodes 30 are formed on the back surface of the photoelectric conversion part 20, the multiple thin wire electrodes may be formed to cover the whole back surface. The present invention should not limit the shape of the thin wire electrodes 30 to be formed on the back surface of the photoelectric conversion part 20.

In addition, while the pair of the sides 12S₂ and 12S₂ are tilted to the light-receiving surface in the fourth embodiment described above, they may also be formed to be perpendicular to the light-receiving surface.

Thus, it is needless to say that the present invention includes various illustrative embodiments that have not been described herein. Hence, a technical scope of the present invention should only be defined by matters specific to the invention according to claims that are reasonable from the above description.

### [Example]

Embodiments of a solar cell module according to the present invention will be specifically described hereinafter. However, the present invention should not be limited to those shown in the following embodiments, but may be modified appropriately and implemented within a scope that does not change the gist thereof.

### (Example 1)

First, photoelectric conversion parts were each fabricated using an n-type single crystal silicon substrate that is 100 mm square. Then, by a screen printing method, thin wire electrodes and connecting electrodes are formed like a grid on a light-receiving surface and a back surface of each photoelectric conversion part by use of a silver paste of epoxy thermosetting type.

Next, flattened wiring members are each solder connected with a connecting electrode formed on the light-receiving surface of one solar cell and a connecting electrode formed on the back surface of another solar cell adjacent to the one solar cell. A solar cell string was fabricated by repeating this.

Then, fluorene acrylate, which is a macromolecule polymer of thermosetting type, was applied onto the light-receiving surface of the solar cell. Next, fluorene acrylate was cured by heating it at 150°C while pressing a top plate that has convex portions corresponding to positions of the thin wire electrodes. As a result, a high refractivity layer having first notches was formed. Additionally, the refractive index of the high refractivity layer was 1.63.

Then, the solar cell module according to Example 1 was manufactured by sealing the solar cell string placed between a glass and a PET film, in an EVA.

### (Example 2)

Then, a solar cell module according to Example 2 was manufactured. Example 2 differs from Example 1 described above in a configuration of the high refractivity layer.

Specifically, a solar cell string was fabricated, similarly to Example 1. Then, polyimide was applied to a light-receiving surface of each solar cell. Next, the polyimide was cured by being heated at 200°C while pressing a top plate that has convex portions corresponding to positions of thin wire electrodes and wiring members against the polyimide. As a result, the high refractivity layer having the first notches and second notches was formed. Additionally, the refractive index of the high refractivity layer was 1.7.

Then, the solar cell module according to Example 2 was manufactured by sealing the solar cell string placed between a glass and a PET film in an EVA.

### (Example 3)

Next, a solar cell module according to Example 3 was manufactured. Example 3 differs from Example 1 described above in a configuration of the high refractivity layer.

Specifically, a solar cell string was fabricated, similarly to the Example 1. Then, an episulfide resin was injected into a mold that has been molded according to the shape of the high refractivity layer. Then, after the episulfide resin was polymerized by being heated at 80°C, the polymerized episulfide resin was annealed at 120°C. As a result, each high refractivity layer having first notches was formed. Additionally, the refractive index of the high refractivity layer was 1.73.

Next, the solar cell module according to the Example 3 was manufactured by sequentially stacking a PET film, EVA, the solar cell string, EVA, high refractivity layers, EVA, and a glass, and then heating the laminated body to pressure bonding these components.

### (Comparative Example)

Next, a solar cell module according to Comparative Example was manufactured. Comparative Example differs from Example 1 described above in that the solar cell module according to Comparative Example includes no high refractivity layer. Thus, no high refractivity material was applied onto the light-receiving surface of each solar cell. Any other processes are similar to those in Example 1 described above.

### (Measurement of Short-Circuit Current)

A short-circuit current of each of the solar cell modules according to Examples 1 to 3 and Comparative Example described above were measured.

The value of short-circuit current in Example 1 was improved by 3.2% relative to that in Comparative Example. This is because light incident toward each thin wire electrode was directed to the photoelectric conversion part by refracting the light by the high refractivity layer having first notches.

In addition, the value of short-circuit current in Example 2 was improved by 4.0% relative to that in Comparative Example. This is because light incident toward each of the thin wire electrodes and wiring members was directed to the photoelectric conversion part by refracting the light by the high refractivity layer having the first notches and second notches. The value of short-circuit current in Example 2 was improved more than that in Example 1, because the light incident toward each wiring member was utilized for photoelectric conversion.

In addition, the value of short-circuit current in Example 3 was improved by 3.3% relative to that in Comparative Example. This is because light incident toward each thin wire electrode was directed to the photoelectric conversion part by refracting the light by the high refractivity layer having the first notches. Thus, it was found that the effect similar to those in Example 1 is achieved even when the high refractivity layer was fabricated as a separate structure.

## Claims

1. A solar cell module in which a first solar cell and a second solar cell are sealed between a front surface protection member and a back surface protection member in a sealing member, the solar cell module comprising
a high refractivity layer provided between the first solar cell and the sealing member and having a refractive index higher than the sealing member, wherein
the first solar cell includes:
a photoelectric conversion part for generating photogenerated carriers by receiving light,
a collecting electrode formed on a light-receiving surface of the photoelectric conversion part, and
the high refractivity layer has a first tilted surface that is provided above the collecting electrode and tilted relative to the light-receiving surface.

2. The solar cell module according to claim 1, wherein the first tilted surface is convexly curved toward the front surface protection member.

3. The solar cell module according to claim 2, wherein
the high refractivity layer has a side connecting between a top of the first tilted surface and the light-receiving surface, and
the first tilted surface and the side form a curved surface.

4. The solar cell module according to any of claims 1 to 3, wherein
the high refractivity layer has an first notch formed along the collecting electrode,
the first notch is formed of a pair of first tilted surfaces that meet each other above the collecting electrode, and
the pair of the first tilted surfaces includes the first tilted surface according to claim 1.

5. The solar cell module according to claim 4, wherein each of the paired first tilted surfaces is flat.

6. The solar cell module according to claim 4, wherein each of the paired first tilted surfaces is convexly curved toward the front surface protection member.

7. The solar cell module according to any of claims 1 to 6, wherein the high refractivity layer is formed along the collecting electrode.

8. The solar cell module according to any of claims 1 to 7, wherein the high refractivity layer is made of a macromolecule polymer.

9. The solar cell module according to any of claims 1 to 8, wherein the high refractivity layer is bonded to the light-receiving surface with a bonding member.

10. The solar cell module according to any of claims 1 to 9, further comprising
a wiring member for electrically connecting the first solar cell and the second solar cell to each other, wherein
the wiring member is placed on the light-receiving surface of the photoelectric conversion part of the first solar cell so as to extend in a predetermined direction, and
the high refractivity layer has a second tilted surface that is provided above the wiring member and tilted relative to the light-receiving surface.

11. The solar cell module according to claim 10, wherein
the high refractivity layer has a second notch formed along the collecting electrode,
the second notch is formed of a pair of second tilted surfaces that meet each other above the wiring member, and
the paired second tilted surfaces includes the second tilted surface according to claim 10.
